(19) Europäisches Patentamt

European Patent Office

Office européen des brevets

(11) EP 1 164 367 A2

(12) EUROPEAN PATENT APPLICATION

(43) Date of publication:
19.12.2001 Bulletin 2001/51

(51) Int Cl.7: G01J 9/00

(21) Application number: 01112280.1

(22) Date of filing: 18.05.2001

(84) Designated Contracting States:
AT BE CH CY DE DK ES FI FR GB GR IE IT LI LU
MC NL PT SE TR
Designated Extension States:
AL LT LV MK RO SI

(30) Priority: 16.06.2000 JP 2000181015

(71) Applicant: Oki Electric Industry Co., Ltd.
Tokyo (JP)

(72) Inventors:
• Yamashita, Yoshio,
Oki Electric Industry Co., Ltd.
Tokyo (JP)
• Fujii, Kozo, c/o Oki Electric Industry Co., Ltd.
Tokyo (JP)

(74) Representative: Betten & Resch
Postfach 10 02 51
80076 München (DE)

(54) **Optical device for use in detecting the wavelength and intensity of light**

(57)     An optical device capable of detecting the intensity and wavelength of light from a light source (LD) with a high level of precision, and an optical module (101) incorporating the optical device (1). The optical device (1) has a planar lightwave circuit (10) having a Y-branched core (16), a silicon substrate (20), a filter block (30), an optical fiber (40), and a first and a second photodiode (PD1, PD2). The end portion (16a) on the input side of the core (16) is connected to the optical fiber (40). One end portion (16b) on the output side of the core (16) is connected to the filter block (30), and the other (16c) on the same side is to the second photodiode (PD2). The light is divided at a predetermined ratio at the Y-branching portion (16h). One of the branched light is sent through the filter block (30) to be input to the first photodiode (PD1), and the other branched light is directly input to the second photodiode (PD2).

FIG.1

EP 1 164 367 A2

## Description

BACKGROUND OF THE INVENTION

Field of the Invention

The present invention relates to an optical device for use in detecting the wavelength and intensity of light.

Description of the Background Art

To cope with recent sharp increase in communication traffic, conventional optical communication widely adopts multiplex communication systems such as TDM (Time Division Multiplexing) and WDM (Wavelength Division Multiplexing) systems.

In the WDM system, wavelength spectral intervals are narrowed to increase the number of multiplexable wavelengths, to thereby afford a huge volume of the traffic. For example, reducing wavelength spectral intervals from 200 GHz to 100 GHz or to 50 GHz can increase the number of multiplexable wavelengths from 32 to 64 or to 128 in the C-band region, respectively. A wavelength spectral interval of 50 GHz allows a large volume transmission of 1 Tbps per an optical fiber or above when the waves of the individual wavelengths are transmitted at a rate of 10 Gbps.

A known light source employed in such an optical communication system includes a semiconductor laser diode such as disclosed in "Development of an FGL for Use in a Wavelength Multiplex Transmission" OPTCOM November 1998, No. 108, pp. 72-73. A typical constitution of a conventional optical module has a semiconductor laser diode, a photodiode, a thermistor and a thermoelectric cooler mounted on a stage enclosed in a package. The optical module has a fibrous Bragg grating at its output end for outputting front light from the laser diode, to thereby stabilize oscillating wavelength of the laser diode. Light output from the laser diode, i.e. front light, is transmitted via an optical fiber to an external optical device.

As is clear from the above, the stability of the wavelength and intensity, or power, of the light output from the light source will be an issue of particular importance in the WDM system when the wavelength spectral interval is narrowed for a huge traffic. The conventional optical module has the photodiode positioned so as to detect back light from the laser diode, to thereby monitor output light from the laser diode. The photodiode is deviated at a predetermined angle away from the optical axis of the back light from the laser diode so as not to allow the light reflected by the photodiode to return into the laser diode. The laser diode is temperature-controlled using a thermoelectric cooler based on the Peltier effect, to thereby stabilize the oscillation wavelength. A problem, however, still remains that the central wavelength of the diode may shift due to changes in threshold voltage or so depending upon a long period of time. Thus there has been a need for precisely monitoring the wavelength or output power of the light.

While a spectrum analyzer will successfully monitor the wavelength of the light in a range as fine as 10 pm, the spectrum analyzer is rather large in size, and it is substantially impossible to integrate the analyzer with the laser diode to provide a modular product.

Japanese patent laid-Open publication No. 209546/1998, corresponding to U.S. patent No. 6,094,446 to Tei et al, discloses a wavelength stabilizing device using an interference optical filter for controlling emitted wavelength of a laser diode. In the wavelength stabilizing device, light emitted from the laser diode is separated into transmitted light and reflected light and are respectively given to two photodiodes. The ratio of outputs from the two photodiodes is calculated using an adder, a subtracter and a numerical divider. The emitted wavelength is controlled so as to clear difference (error) between the output ratio and a reference value.

The wavelength stabilizing device described in Japanese publication No. 209546/1998 indicated above, however, needs a precise three-dimensional adjustment of the optical axes of an optical fiber for transmitting light, an interference filter and the photodiode, and thus it has been not easy to integrate these elements with a laser diode to thereby provide a modular product. That difficulty in the adjustment of the optical axes is an obstacle to cost reduction of the product.

Moreover, there is a growing need for further downsizing the optical module in order to suppress size expansion of an optical transmitter/receiver in accordance with a recent increase in the number of WDM channels. Providing a module by integrating the laser diode with the wavelength stabilizing device described in Japanese publication No. 209546/1998, however, cannot accomplish downsizing of the optical module to a satisfactory degree.

SUMMARY OF THE INVENTION

It is therefore an object of the present invention to provide an optical device which allows precise detection of the wavelength and intensity of light emitted from a light source.

In accordance with one aspect of the present invention, provided is an optical device which comprises an optical divider for dividing received light into at least a first light and a second light with a predetermined ratio; an optical filter for receiving the first light and selectively passing light of a specific wavelength; a first photosensitive device for receiving the light transmitted from the optical filter; and a second photosensitive device for receiving the second light. According to the constitution, the intensity of a first light of a predetermined wavelength (the intensity of transmitted light through the optical filter) is detected by a first photosensitive device, and the intensity of a second light is detected by a second photosensitive device. This allows calculation of the intensity and wavelength of the light emitted from a light source based on the detection results.

In accordance with another aspect of the invention, provided is an optical device which comprises a photosensitive device placed on a path of light; and an optical filter movable between a first position at which light is input and a second position at which light is not input for passing light of a specific wavelength; wherein the photosensitive device receives light transmitted through the optical filter when the optical filter is positioned at the first position, and directly receives the light when the optical filter is positioned at the second position. According to the constitution, only a single photosensitive device can detect both of the intensity of the light emitted from the light source and the intensity of the light of a predetermined wavelength passed through the optical filter.

As is described in the above, the present invention can provide an optical device capable of detecting the intensity and wavelength of the output light from a light source with a high level of precision. The present invention can also provide an optical device capable of guiding the transmitted light to a utility device without causing diffusion thereof.

BRIEF DESCRIPTION OF THE DRAWINGS

The objects and features of the present invention will become more apparent from consideration of the following detailed description taken in conjunction with the accompanying drawings in which:

FIG. 1 is a perspective view showing the constitution of an optical device according to an embodiment of the present invention;

FIG. 2 is a schematic block diagram showing the constitution of an optical module incorporating the optical device shown in FIG. 1;

FIGS. 3A, 3B and 3C are views useful for understanding the positional relation of a planar lightwave circuit, a filter block, and photodiodes provided for the optical device shown in FIG. 1;

FIGS. 4A to 4G are views useful for understanding the process steps for fabricating the planar lightwave circuit provided for the optical device shown in FIG. 1, and FIG. 4H is a plan view given by viewing FIG. 4E from the top;

FIGS. 5A and 5B are perspective views showing the constitution of a filter block provided for the optical device shown in FIG. 1 according to an alternative embodiment of the present invention;

FIG. 6 is a perspective view showing another constitution of an optical device differing from that shown in FIG. 1;

FIG. 7 is a view useful for understanding the positional relation of a planar lightwave circuit and a filter block provided for the optical device shown in FIG. 6;

FIG. 8 is a perspective view showing another constitution of an optical device differing from those shown in FIGS. 1 and 6;

FIG. 9 is a schematic block diagram showing the constitution of an optical device according to a further alternative embodiment of the present invention;

FIG. 10 is a schematic block diagram showing another constitution of an optical device differing from those shown in FIGS. 2 and 9;

FIG. 11 is a schematic block diagram showing another constitution of an optical device differing from those shown in FIGS. 2, 9 and 10;

FIG. 12 is a schematic block diagram showing a constitution of an optical module according to a further alternative embodiment of the present invention;

FIG. 13 is a partially cut-out, perspective view showing the constitution of an optical module according to a still further alternative embodiment of the present invention;

FIG. 14 is a plan view showing the constitution and functions of an optical device provided for the optical module shown in FIG. 13;

FIG. 15 is a partially cut-out, perspective view showing the constitution of an optical module according to a still further alternative embodiment of the present invention;

FIG. 16 is a plan view showing the constitution and functions of an optical device provided for the optical module shown in FIG. 15; and

FIG. 17 is a partially cut-out, perspective view showing the constitution of a conventional optical device.

DESCRIPTION OF THE PREFERRED
EMBODIMENTS

With reference to the accompanying drawings, preferred embodiments of an optical device of the present invention will be detailed. It should now be noted that in the description below and the accompanying drawings, like components will be denoted with the same reference numerals to thereby omit redundant description.

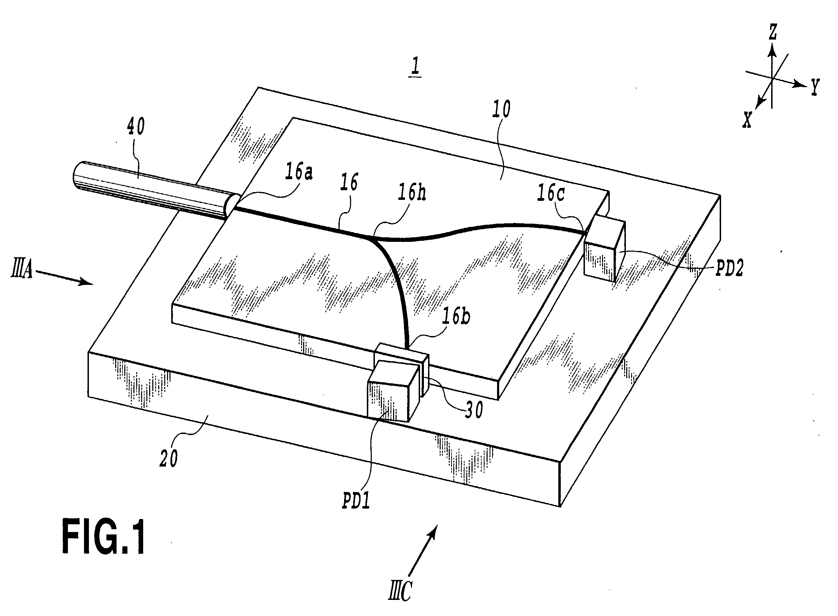

The constitution of an optical device 1 according to a preferred embodiment of the present invention is shown in FIG. 1. The optical device 1 has an optical waveguide, preferably a planar lightwave circuit (PLC), having therein a core 16 running in a Y-shape in its plan view, a silicon substrate 20, a filter block 30, an optical fiber 40, and photodiodes PD1 and PD2. The core 16 has an end portion 16a (introduction end) on its input side optically connected to the optical fiber 40 immobilized in a V-shaped groove. The core 16 also has one end portion 16b (emission end) on its output side optically connected to the filter block 30, and the other end portion 16c (emission end) also optically connected to the photodiode PD2. The description will be made hereinafter assuming the direction of height (thickness) of the substrate 20 as Z axis, and the planar direction normal thereto as X and Y axes orthogonal with each other.

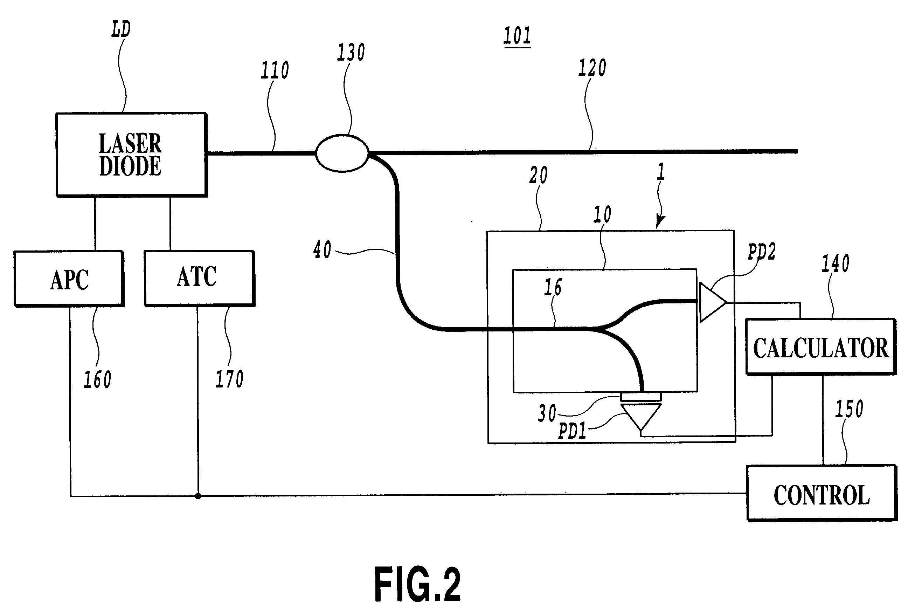

FIG. 2 shows an optical module 101 having the optical device 1 incorporated therein. The optical module 101 has the optical device 1, a laser diode LD, optical fibers 110 and 120, a coupler 130, a calculating circuit 140, a control circuit 150, an APC (automatic power control) circuit 160, and an ATC (automatic temperature control) circuit 170.

The functions of the individual components of the optical module 101 and the layout of the connection will be described. Laser light emitted from the laser diode LD is transmitted through the optical fiber 110 to be input to the coupler 130, where the laser light is branched at a ratio of 5 : 95, for example. Ninety-five percent of the light is directed by the optical fiber 120 to an optical communication or measurement circuit, for example. Residual 5% is directed by the optical fiber 40 to the core 16 of the planar lightwave circuit 10 provided to the optical device 1.

At the Y-branching portion 16h, the light is branched at a predetermined ratio (50 : 50, for example), one of which is then sent via the filter block 30 to be input to the one photodiode PD1, and the other is input to the other photodiode PD2.

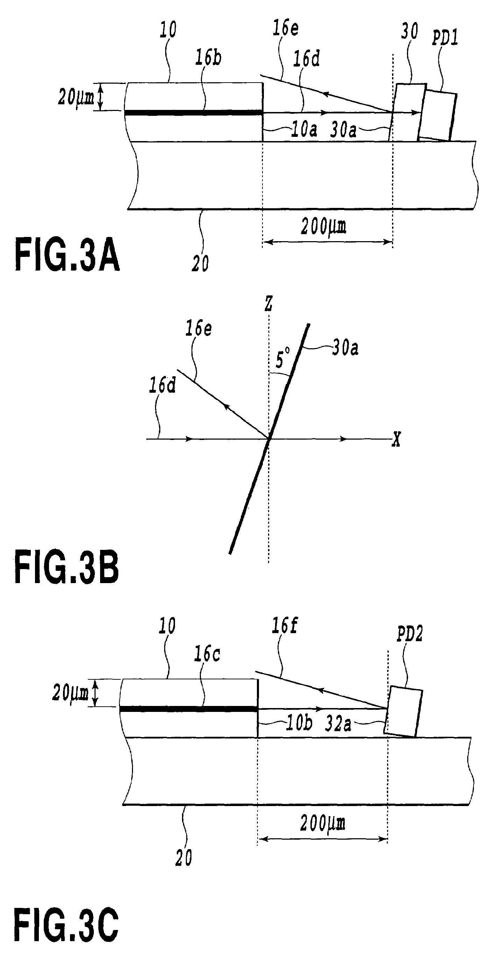

Now the light input from the core 16 through the optical filter 30 to the one photodiode PD1 is partially reflected on the incident plane or surface of the optical filter 30. Similarly, the light input from the core 16 to the other photodiode PD2 is partially reflected on the incident plane of the photodiode PD2. In the optical device 1, the positions and angles of the filter block 30 and photodiodes PD1 and PD2 relative to those of the planar lightwave circuit 10 are properly adjusted so as to prevent the respective reflected lights from being returned to the core 16. This will be detailed referring to FIGS. 3A to 3C.

FIG. 3A is a schematic, partial side view of the optical device 1 as viewed from an arrow IIIA in FIG. 1. The core 16 is now formed in a depth of 20 $\mu$m from the surface of the planar lightwave circuit 10. In this case, a distance between an end plane 10a of the planar lightwave circuit 10, from which light 16d is emitted, and an end plane 30a of the filter block 30, to which the light 16d is received, is adjusted to 200 $\mu$m. The filter block 30 is further angle-adjusted as shown in FIG. 3B so as to have the end plane 30a thereof slants by 5° away from the Z axis. Such positional and angular adjustments of the filter block 30 allow light 16e reflected on the end plane 30a of the filter block 30 to propagate toward an upper space over the planar lightwave circuit 10. That is, the light 16e is successfully prevented from being returned from the filter block 30 to the core 16.

Similarly, as shown in FIG. 3C, which is also a schematic partial side view as viewed from an arrow IIIC in FIG. 1, also the photodiode PD2 is adjusted so as to have the end plane 32a thereof distant by 200 $\mu$m from the end plane 10b of the planar lightwave circuit 10, and slants by 5° away from the Z axis. Such positional and angular adjustments of the photodiode PD2 allow light 16f reflected on the end plane 32a of the photodiode PD2 to propagate toward an upper space above the planar lightwave circuit 10. That means that the light 16f is successfully prevented from being returned from the photodiode PD2 to the core 16.

The filter block 30 characteristically extracts a spectrum which resides in a certain narrow wavelength range. Such a wavelength range is selected as to match the wavelength of the output light required for the laser diode LD. Since the light 16d emitted from the core 16b of the planar lightwave circuit 10 is transmitted through the filter block 30, the light input to the photodiode PD1 will have only a selected wavelength after being filtered by the filter block 30. Thus the photodiode PD1 detects the light received from the core 16b of the planar lightwave circuit 10 via the filter block 30, and outputs a result from the detection in the form of voltage signal V1.

On the other hand, the other photodiode PD2 directly receives the light output from the core 16c of the planar lightwave circuit 10, and outputs a detection result in the form of voltage signal V2.

The voltage signals V1 and V2 from the photodiodes PD1 and PD2, respectively, are input to the calculator circuit 140, where a value expressed by an expression (V2 - V1)/V1 = S is obtained. The calculated value S and the voltage signal V2 are in turn sent to the control circuit 150.

The control circuit 150 preliminarily stores the functions defining the relationships between the target intensity values of the output light of the laser diode LD and the voltage signals V2, and the functions defining the relationships between the target wavelength values and the calculated values S. The control circuit 150 can thus determine the intensity and wavelength of the output light from the laser diode LD at that time using these functions, voltage signal V1 and calculated value S. Then the control circuit 150 controls, using the APC circuit 160 and ATC circuit 170, the laser diode LD so that the intensity and wavelength of the output thereof will match the target values (designed values) in a real time manner. Thus the laser light stable enough in intensity and wavelength can be supplied from the optical module 101 to an external utility optical device.

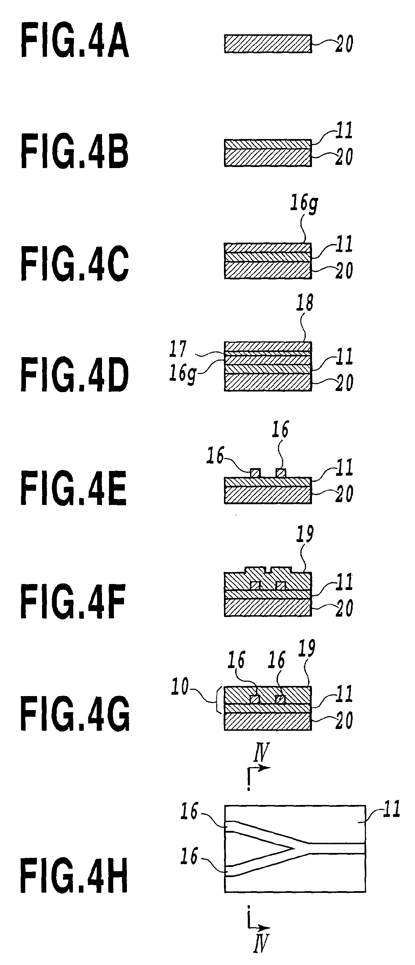

Next, the process steps of fabricating the planar lightwave circuit 10 will be described referring to FIGS. 4A to 4H. First, a quartz film is deposited on the silicon substrate 20 using a plasma CVD (chemical vapor deposition) apparatus, to thereby form a lower clad layer 11, FIGS. 4A and 4B. The process in this step will be detailed.

A cleaned silicon substrate 20 is placed on a substrate stage in a chamber of the plasma CVD apparatus , and is then heated to a temperature of 400°C. The atmosphere within the chamber is evacuated to 1 Pa using a rotary pump, and further evacuated as low as 1 x 10$^{-5}$ Pa using a turbo molecular pump.

The chamber is then supplied with 12 sccm of TRIES (triethoxy silane) or TEOS (tetraethoxy silane), 400 sccm of oxygen, 6 sccm of TMB (trimethoxy boron) and 1 sccm of TMP (trimethoxy phosphorus) through an upper electrode. TRIES or TEOS is preliminarily gasified by heating to 80 °C, and TMB and TMP to 38 °C. TMB and TMP are used to the lower refractive index of the lower clad layer 11 and an upper clad layer 19, described later, by approximately 0.5% than that of the Ge-doped core 16.

While keeping the pressure in the chamber constant at 30 Pa, a radio frequency (13.56 MHz) voltage is applied between the upper electrode and the substrate stage so as to attain a electric power density of 1.6 W/cm$^2$. This excites a plasma within the chamber and a quartz film (lower clad layer 11) of approximately 25 μm thick is deposited on the silicon substrate 20 over 2 hours and 12 minutes. The lower clad layer 11 has a refractive index of 1.4465 for a light with a wavelength of 1.3 μm.

Another quartz film is then deposited on the lower clad layer 11 using the plasma CVD apparatus, to thereby form a core layer 16g later fabricated to yield the core 16, FIG. 4C. The process will be detailed below.

The silicon substrate 20 having the lower clad layer 11 formed thereon is heated to 400 °C. The inner atmosphere of the chamber is evacuated to 1 x 10$^{-3}$ Pa using a turbo molecular pump.

Then 12 sccm of TRIES or TEOS, 1 sccm of TMG (trimethyl germanium), and 400 sccm of oxygen are introduced into the chamber through the upper electrode.

While keeping the inner pressure of the chamber constant at 30 Pa, a radio frequency (13.56 MHz) voltage is applied between the upper electrode and the substrate stage so as to attain a electric power density of 1.6 W/cm$^2$. This excites a plasma within the chamber and a quartz film (core layer 16g) of approximately 8 μm thick is deposited on the lower clad layer 11 over 50 minutes. The core layer 16g has a refractive index of 1.4538 for a light with a wavelength of 1.3 μm.

The chamber is then once evacuated and then introduced with nitrogen gas to recover the atmospheric pressure, and the silicon substrate 20 is taken out.

Then a WSi$_x$ film 17 of 1 μm thick is then deposited on the core layer 16g by RF sputtering, a resist film 18 is formed by resist coating on the WSi$_x$ film 17, and the resist film 18 is patterned by light exposure and development according to a pattern for forming the core 16, FIG. 4D.

The silicon substrate 20 having thereon the resist film 18 patterned by light exposure and development to have a pattern of the core 16 is then transferred to a chamber of a reactive ion etching apparatus. The chamber is evacuated to 1 Pa using a rotary pump, and then further evacuated to 1 x 10$^{-3}$ Pa using a turbo molecular pump. The chamber is then supplied with 100 sccm of Cl$_2$ gas.

While keeping the pressure of the chamber constant at 2 Pa, a radio frequency (13.56 MHz) voltage is applied between the upper electrode and the substrate stage so as to attain a electric power density of 1 W/cm$^2$. This excites a plasma within the chamber, and the WSi$_x$ film 17 is etched as being partially masked with the patterned resist film 18. The RF discharge and Cl$_2$ gas introduction are stopped after 20 minutes, and the atmosphere is evacuated again to 1 x 10$^{-3}$ Pa using the rotary pump and the turbo molecular pump in this order. The chamber is then supplied with 100 sccm of CHF$_3$ gas.

While keeping the pressure of the chamber constant at 2 Pa, a radio frequency (13.56 MHz) voltage is applied between the upper electrode and the substrate stage so as to attain a electric power density of 1 W/cm$^2$. This excites a plasma within the chamber, and the core layer 16g is etched as being partially masked with the patterned WSi$_x$ film 17, to thereby form the core 16. FIG. 4H is a plan view as viewed from the top of the clad layer 11 shown in FIG. 4E. FIG. 4E is an end elevation taken along a section indicated by an arrow IV in FIG. 4H. The RF discharge and CHF$_3$ gas introduction are stopped after 60 minutes, and the atmosphere is evacuated again to 1 x 10$^{-3}$ Pa using the rotary pump and the turbo molecular pump in this order.

The chamber is then introduced with nitrogen gas to recover the atmospheric pressure, and the silicon substrate 20 is taken out.

The resist film 18 is then removed by oxygen plasma ashing and successive solution cleaning (at 85°C, using sulfuric acid : hydrogen peroxide = 3 : 1). The silicon substrate 20 is further washed with pure water. Thus the core 16 (6 μm wide and 6 μm high) having the Y-branching portion 16h is obtained, FIG. 4E.

Next, still another quartz film is deposited on the lower clad layer 11 and the core 16 using the plasma CVD apparatus, to thereby form the upper clad layer 19, FIG. 4F. The process will be detailed below.

The silicon substrate 20 having the core 16 formed thereon is placed on the substrate stage in the chamber of the plasma CVD apparatus.

Then 12 sccm of TRIES or TEOS, 6 sccm of TMB, 1 sccm of TMP, 400 sccm of oxygen, and 400 sccm of argon are introduced into the chamber through the upper electrode.

While keeping the inner pressure of the chamber constant at 30 Pa, a radio frequency (13.56 MHz) voltage is applied between the upper electrode and the substrate stage so as to attain a electric power density of 1.6 W/cm$^2$. This excites a plasma within the chamber and a boron- and phosphorus-doped quartz film (BPSG, upper clad layer 19) of approximately 15 μm thick is deposited on the lower clad layer 11 and the core 16 over 84 minutes. The upper clad layer 19 has a refractive index of 1.4465 for a light with a wavelength of 1.3 μm.

The silicon substrate 20 having the upper clad layer 19 formed thereon is placed in a quartz-made lateral furnace, and heated to approximately 900°C for 30 minutes under an oxygen atmosphere. The lateral furnace is preheated at 400 °C, and heated after the setting of the silicon substrate 20 at a rate of 5 °C/min up to 900 °C. Cooling from 900 °C to 400 °C is effected at a rate of 2 °C/min. The silicon substrate 20 is taken out when the furnace is cooled to 400 °C. Thus the planar lightwave circuit 10 is finished, FIG. 4G.

As has been described in the above, the optical device 1 according to this embodiment has the lightwave circuit 10 of a planar structure, and two-dimensionally connected thereto the optical fiber 40, photodiodes PD1 and PD2, and filter block 30 without using any of coupler, tap nor connector. That constitution can provide an optical device markedly reduced in size as compared with the conventional optical devices. Specifically, the optical device 1 according to this embodiment can be implemented as a 10 mm x 10 mm product.

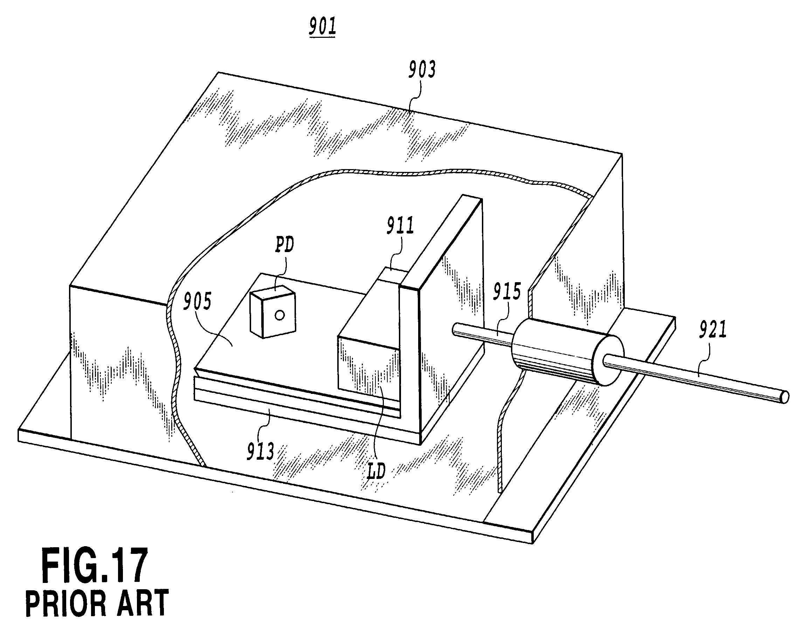

Now the exemplary constitution of a conventional optical device is described for reference, referring to FIG. 17. The conventional optical device 901 has a semiconductor laser diode LD, a photodiode PD, a thermistor 911 and a thermoelectric cooler 913, which are mounted on a stage 905 enclosed in a package 903. The optical module 901 also has a fibrous Bragg grating 915 at its output end for outputting front light from the laser diode LD, to thereby stabilize the oscillating wavelength of the laser diode LD. Light (front light) output from the laser diode LD is transmitted over an optical fiber 921 to an external optical device, not shown. The two-dimensional size of a conventional optical device which would have the functions equivalent to those of the optical device 1 would be as large as approximately 40 mm x 20 mm at the smallest. It can thus be said that the optical device 1 of the present embodiment succeeded in achieving 1/8 downsizing on the volume basis as compared with the conventional optical device. Incorporating the optical device 1 also allows downsizing of the optical module 101.

According to the optical device 1 of the instant embodiment, the light is branched with a predetermined ratio (50 : 50, for example) at the Y-branching portion of the core 16 formed in the planar lightwave circuit 10. Assuming now the branching ratio is 50 : 50, the rate of transmission of the filter block 30 is T% , and that both photodiodes PD1 and PD2 have the same photosensitivity as each other, then the relationship between the signal voltage V1 output from the one photodiode PD1 and the signal voltage V2 output from the other photodiode PD2 is given by an expression below:

$$V1 = T \cdot V2/100.$$

Then the calculated value S obtained from the calculating circuit 140 will be given as

$$S = (V2 - V1)/V2 = 1 - T/100.$$

As is clear from the above, the calculated value S does not depend on the intensity of output light from the laser diode LD but is expressed as, i.e. depends upon, the function of transmittivity T only. This allows a precise monitoring of the wavelength of the output light from the laser diode LD. The characteristics of the filter block 30 can more precisely be understood by performing the A/D (analog-to-digital) conversion of the voltage signal V2 output from the photodiode PD2 and the calculated value S output from the calculating circuit 140 and processing using a personal computer or a DSP (digital signal processor), which allows the control of the laser diode LD with an improved accuracy.

It is also allowable to monitor the temperature of the filter block 30 by mounting thereon a temperature-sensitive device, not shown, such as a thermistor. Thus the dispersion in characteristics of the filter block 30 can properly be corrected, which allows precise data to be obtained on the wavelength of the laser light.

As has been described in the above, since the optical device 1 according to the instant embodiment allows precise monitoring of the intensity and wavelength of the output light from the laser diode LD, the optical module 101 having the optical device 1 incorporated therein can output laser light whose intensity and wavelength are controlled with an excellent accuracy.

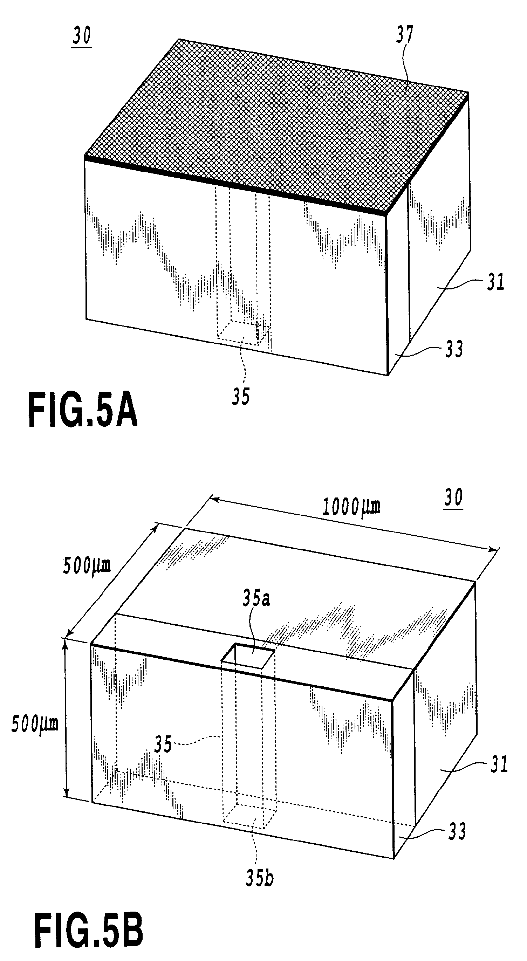

Next, the details of the filter block 30 provided to the optical device 1 of the illustrative embodiment, and an alternative embodiment of the planar lightwave circuit 10 will be described. First, the constitution of the filter block 30 will be described referring to FIGS. 5A and 5B. FIG. 5A is a perspective view showing a finished assembly of the filter block 30, and FIG. 5B is a perspective view showing the same except that a dielectric multi-layered film 37 is removed for the convenience of explanation.

The filter block 30 comprises, as shown in FIG. 5A, a quartz substrate 31, an optical waveguide 33 and a dielectric multi-layered film 37. To fabricate the filter block 30, the optical waveguide 33 having a core 35 is formed on a quartz substrate 31 of a predetermined size according to approximately similar processes as those for fabricating the planar lightwave circuit 10 shown in FIGS. 4A to 4H. Next, as shown in FIG. 5B, the quartz substrate 31 having the optical waveguide 33 stacked thereon is cut in the longitudinal direction of the core 35 so as to locate the core 35 at the center of the optical waveguide 33. The quartz substrate 31 is further cut now in the direction substantially normal to the longitudinal direction of the core 35, to thereby expose both end planes of the core 35. By the cutting procedures, a rectangular parallelepiped in a size of 500 x 1000 x 500 μm is obtained.

On the rectangular parallelepiped, a dielectric multi-layered film 37 is formed so as to cover one end surface 35a of the core 35 as shown in FIG. 5A, to thereby finish the filter block 30. It is now also allowable to form a film, not shown, equivalent to the dielectric multi-layered film 37, on the other end surface 35b of the core 35 while the former end surface 35a being covered with the dielectric multi-layered film 37.

The conventional optical device had a wavelength filter which was composed of a vapor-deposited layer having a different refractive index with that of a quartz substrate, on which such layer is stacked, which is transparent with respect of a wavelength of the light to be transmitted. If such a conventional wavelength filter, in place of the foregoing filter block 30, were adopted to the optical device 1 according to the early described embodiment, the light emitted from the planar lightwave circuit 10 would then be undesirably diffused after passing through such a wavelength filter, and be very likely to degrade the photo detection efficiency of the photodiode PD1.

By contrast, the filter block 30 according to the instant embodiment can introduce input light to the photodiode PD1 via the dielectric multi-layered film 37 as a filter and the core 35 directly connected to the dielectric multi-layered film 37. That allows light loss on the path between the filter block 30 and the photodiode PD1 to be minimized, which allows precise monitoring of the wavelength of the output light from the laser diode LD.

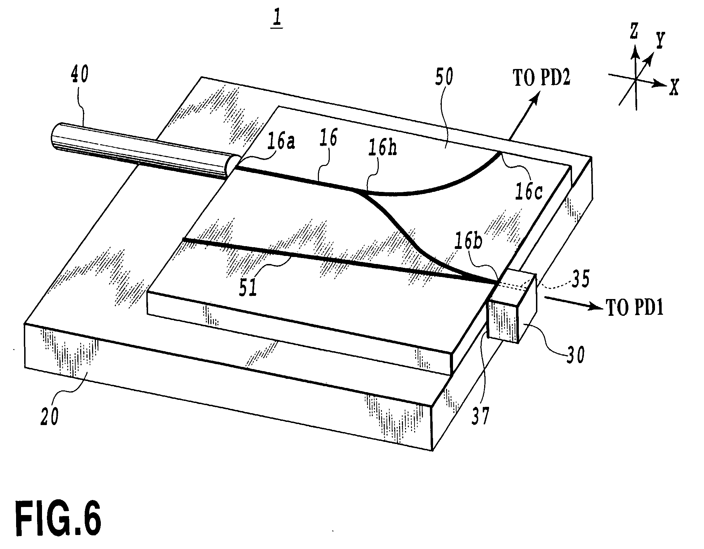

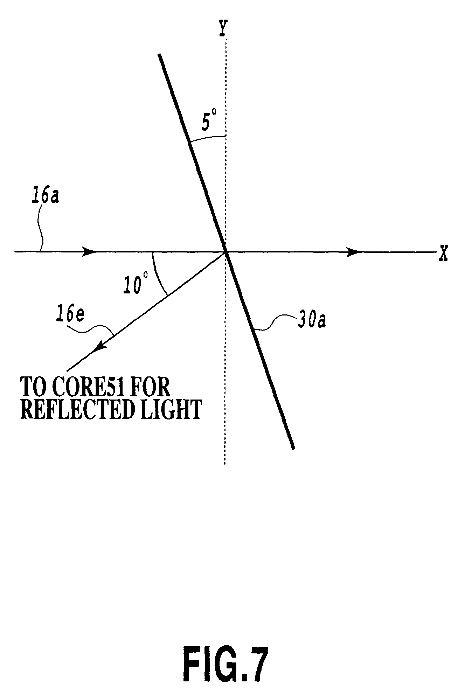

Next, another constitution of a planar lightwave circuit 50, which is different from that of the planar lightwave circuit 10, and a method of connecting the planar lightwave circuit 50 with the filter block 30 will be described referring to FIGS. 6 and 7. The planar lightwave circuit 50 is composed of, as shown in FIG. 6, the planar lightwave circuit 10 added with a core for reflected light 51, the constitution of which is approximately the same. The description will be made hereinafter assuming the direction of height (thickness) of the substrate 20 as Z axis, and the planar direction normal thereto as X and Y axes, as shown in FIG. 6.

The filter block 30 is directed so that the dielectric multi-layered film 37 thereof is positioned on the side of the planar lightwave circuit 50, and fixed to the planar lightwave circuit 50 using, for example, a UV (ultra-violet) curing adhesive. The core 35 provided to the filter block 30 and the core 16 provided to the planar lightwave circuit 50 are thus optically connected with each other.

The filter block 30 is further angle-adjusted so that the incident plane or surface 30a (dielectric multi-layered film 37) thereof will slant by 5° away from the Y axis. This means incident light 16d from the core 16 to the filter block 30 will have an incident angle of 5° with respect to the major surface 30a of the dielectric multi-layered film 37. The incident light 16d coming to the dielectric multi-layered film 37 not only gives a transmitted light but also gives a reflected light 16e which is 10° away from the incident light 16d (at a reflection angle of 5°). Since the planar lightwave circuit 50 has the core for reflected light 51 extending to the direction of the reflected light 16e, the reflected light 16e can be guided by the core for reflected light 51 toward a space having no light-susceptible device (the opposite side of the planar lightwave circuit 50 as viewed from the filter block 30 in FIG. 6).

Such a connection of the filter block 30 and the planar lightwave circuit 50 allows the reflected light 16e from the incident plane 30a of the filter block 30 to be diverted in the direction not responsible for returning the light toward the light source. This successfully avoids the interference of the light which would be caused by undesirably returning the reflected light 16e toward the light source.

In the optical device 1 according to the early described embodiment, the filter block 30 is adjusted in angle so as to direct the end plane 30a thereof 5° away from the Z axis, so that the light reflected on the end plane 30a of the filter block 30 propagates toward the upper space over the planar lightwave circuit 10 rather than being returned to the core 16. Such a constitution is advantageous in preventing interference with the laser light output from the laser diode LD similarly to the present embodiment. It should now be noted that the present embodiment is preferably employed for an application in which a sufficient space is not available over the planar lightwave circuit 10. The angle between the filter block 30 and the Y axis (or Z axis) is by no means limited to 5°, but can arbitrarily be selected within a range from 1 to 45°.

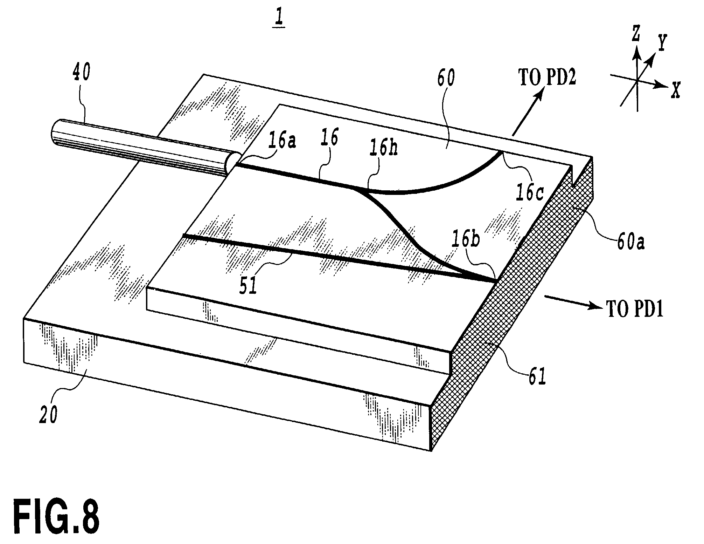

It is also allowable to adopt another planar lightwave circuit 60 shown in FIG. 8 in place of the filter block 30 and the planar lightwave circuit 50. The planar lightwave circuit 60 is angularly adjusted so that the end plane 60a thereof for emitting light toward the photodiode PD1 slants by 5° away from the Y axis. The end plane 60a has a dielectric multi-layered film 61 coated thereon. The incident light from the core 16b to the dielectric multi-layered film 61 will therefore have an incident angle of 5°. The incident light which comes to the dielectric multi-layered film 61 not only gives a transmitted light but also gives a reflected light which is 10° away from the incident light (at a reflection angle of 5°). Since the planar lightwave circuit 60 has the core for reflected light 51 extending to the direction of the reflected light, the reflected light can be guided by such a core for reflected light 51 toward a space having no light-susceptible device (the opposite side of the planar lightwave circuit 60 as viewed from the dielectric multi-layered film 61 in FIG. 8).

As is clear from the above, the planar lightwave circuit 60 does not require the filter block 30 together with the dielectric multi-layered film 37, which can provide a compacter optical device.

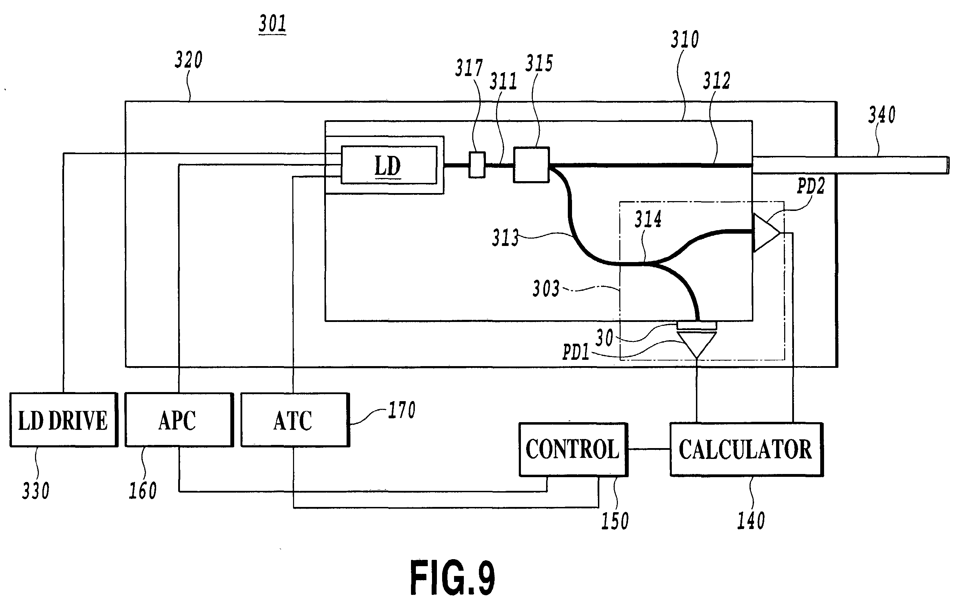

An optical module 301 according to a further alternative embodiment of the present invention is shown in FIG. 9. The optical module 301 has a silicon substrate 320, and a planar lightwave circuit 310 formed thereon.

The planar lightwave circuit 310 can be fabricated by a method almost similar to that for the planar lightwave circuit 10 shown in FIGS. 4A to 4H, and has cores 311, 312 and 313. The planar lightwave circuit 310 has mounted thereon a laser diode LD optically connected to the core 311. The laser diode LD has a mode conversion function, to thereby achieve low loss in optical coupling with the core 311. The core 311 also has inserted therein an isolator 317 for preventing the light output from the laser diode LD from being returned again thereto.

The cores 312 and 313 are connected to the core 311 via a directional coupler 315. The directional coupler 315 is adapted to divide the light from the core 311 at a predetermined ratio, and to transmit the divided lights respectively into the cores 312 and 313. For example, 95% of the light is introduced into the core 311 and 5% into the core 313.

The core 313 has a Y-branching portion 314, where the light is branched at a predetermined ratio (50 : 50, for example), one of which is then sent via the filter block 30 to be input to the photodiode PD1, and the other is input to the other photodiode PD2. That is, the optical module 301 of the present embodiment is provided with an optical monitor 303 which comprises the core 313, filter block 30, and photodiodes PD1 and PD2. The constitution and functions of the optical monitor 303 are equivalent to those of the foregoing optical device 1.

In the external of, or on, the silicon substrate 320, provided are a calculating circuit 140, a control circuit 150, an APC circuit 160, an ATC circuit 170, and an LD drive circuit 330 for driving the laser diode LD.

The operation of the thus constituted optical device 301 according to the present embodiment will be described. The laser diode LD, driven by the LD drive circuit 330, emits a laser light to the core 311 after being converted into a single-mode light by the mode conversion function. The laser light beam input into the core 311 is then transmitted through the isolator 317 to the directional coupler 315, where the light beam is divided at a ratio of 95 : 5. Ninety-five percent of the light is directed by the optical fiber 340, connected to the core 312, to an external optical device, not shown. Residual 5% is introduced into the core 313, and is further divided at the Y-branching portion thereof at a ratio of 50 : 50. One of the thus divided light is guided through the filter block 30 to be input into the photodiode PD1. The other portion of the divided light is input to the photodiode PD2.

The photodiode PD1 detects the intensity of the light received from the core 313 of the planar lightwave circuit 310 via the filter block 30, and outputs a detection result after converted into a voltage signal V1.

On the other hand, the photodiode PD2 directly receives the light output from the core 313 of the planar lightwave circuit 310, detects the intensity of the light, and outputs a detection result in the form of voltage signal V2.

Successive signal processing to obtain the calculated value S, and the real-time control of the laser diode LD are carried out in the same manner as described for the early described embodiment.

As described in the above, since the optical module 301 is provided with the optical monitor 303 capable of exactly monitoring the intensity and wavelength of the light, the module 301 can output the light produced by the laser diode LD after being precisely adjusted for intensity and wavelength.

Integrating the optical monitor 303 and the laser diode LD on the silicon substrate 320, and optically connecting them with the planar lightwave circuit 310 are successful in downsizing of the optical module 301.

While the laser diode LD in the optical device 101 previously shown in FIG. 2 is connected to the optical fiber 110, the connection of the both elements requires three-dimensional alignment and assembly process therefor may not be simple. By contrast, with the optical module 301 according to the present embodiment, the laser diode LD can optically connected to the core 311 formed in the planar lightwave circuit 310 only by two-dimensional alignment. This desirably reduces the number of assembly steps and thus improves the product quality. The optical monitor 303 is further advantageous in that it can be fabricated together with a peripheral circuit of the laser diode LD in a series of process steps, which results in reduction in the production cost.

Possible candidates for the laser diode LD include those of Fabry-Perot type, DFB (Distributed Feed-Back) laser diode and EA (Electrical Absorption) laser diode.

While the optical monitor 303 of the optical module 301 shown in FIG. 9 is adapted to monitor the light branched from the front light of the laser diode LD, it is also allowable to monitor the back light.

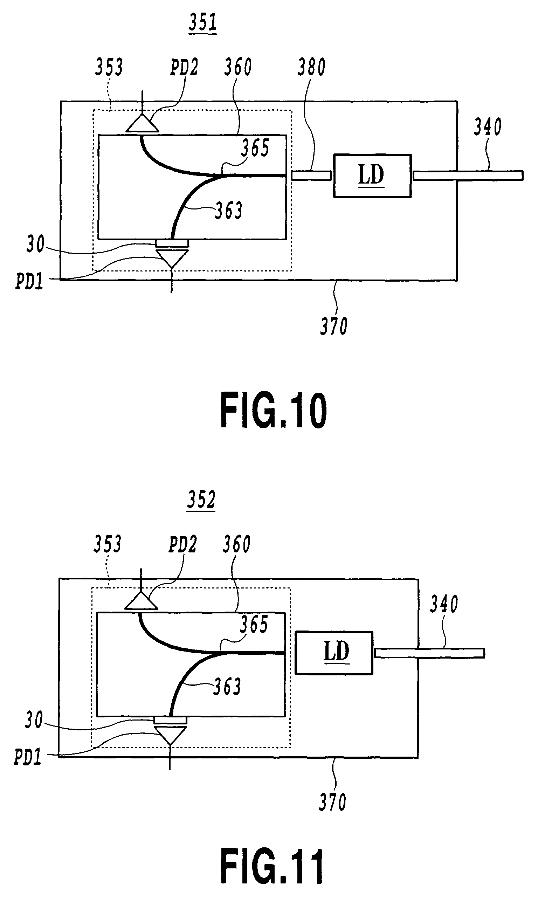

FIGS. 10 and 11 respectively illustrate optical modules 351 and 352 which have an optical device 353 for monitoring the back light of the laser diode LD. The optical module 351 has a silicon substrate 370 and a planar lightwave circuit 360 formed thereon. The planar lightwave circuit 360, having a core 363, is fabricated by a method equivalent to that for fabricating the planar lightwave circuit 10 previously shown in FIG. 4.

The silicon substrate 370 has the laser diode LD mounted thereon. The front light emitting portion of the laser diode LD is optically connected to the optical fiber 340, and the back light emitting portion thereof is optically connected to the core 363 via the optical fiber 380. The optical fibers 340 and 380 are individually laid in a V-groove formed in the silicon substrate 370.

The core 363 formed in the planar lightwave circuit 360 has a Y-branching portion 365, where the back light from the laser diode LD is divided at a predetermined ratio (50 : 50, for example). One of the thus divided light is guided through the filter block 30 to be input into the photodiode PD1. The other portion of the divided light is input to the photodiode PD2. Thus the optical module 351 has an optical device 353 which is composed of the core 363, filter block 30, and photodiodes PD1 and PD2. The constitution and functions of the optical device 353 are equivalent to those of the foregoing optical device 1.

In the external of, or on, the silicon substrate 370, provided are a calculating circuit 140, a control circuit 150, an APC circuit 160, an ATC circuit 170, and an LD drive circuit 330 for driving the laser diode LD, although not shown in FIG. 10.

On the other hand the optical module 352 shown in FIG. 11 has, similarly to the optical module 351, the silicon substrate 370 and the planar lightwave circuit 360 formed thereon. The silicon substrate 370 has formed thereon the laser diode LD. The front light emitting portion of the laser diode LD is optically connected to the optical fiber 340, but the back light emitting portion thereof is directly connected to the core 363 without being interposed with the optical fiber unlike the case for the optical module 351.

Other details of the constitution of the optical module 352 are equivalent to those of the optical module 351. While the laser diode LD in the optical module 352 is mounted on the silicon substrate 370, it may be located on the planar lightwave circuit 360 together with the optical device 353 similarly to the optical module 301 of the third embodiment previously shown in FIG. 9.

The optical modules 351 and 352 enable monitoring using the back light of the laser diode LD. More specifically, the monitoring of the intensity and wavelength of the output light of the laser diode LD no more requires branching of the front light which is used for a carrier wave of optical communications. This is advantageous in making more effective use of the output light from the laser diode LD, as well as obtaining effects equivalent to those of the optical module 301 of the immediately preceding embodiment.

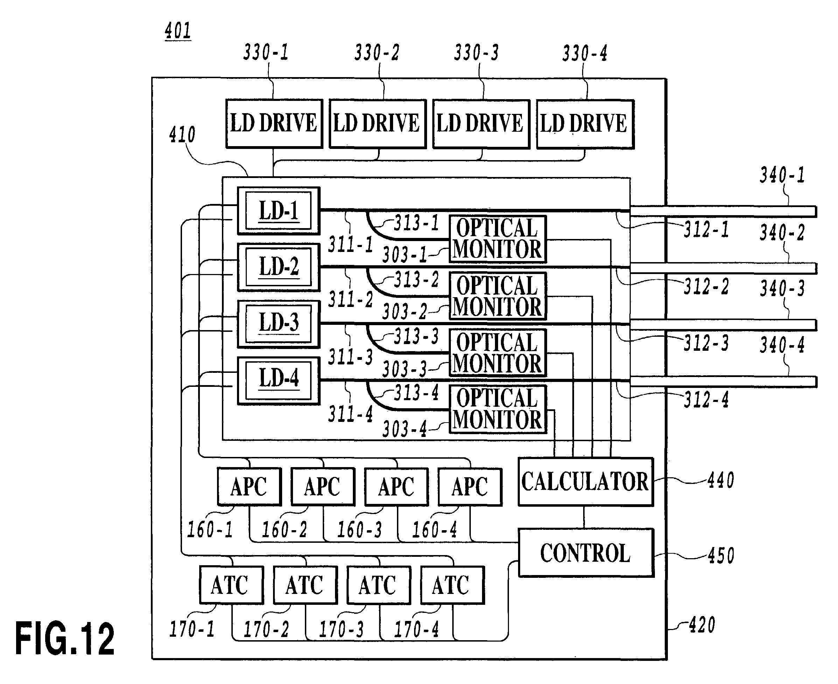

FIG. 12 shows an optical module 401 according to a still further alternative embodiment of the present invention. The optical module 401 has a silicon substrate 420 and a planar lightwave circuit 410 formed thereon. The optical lightwave circuit 410 has mounted thereon four laser diodes LD-1, LD-2, LD-3 and LD-4. The laser diodes LD-1 to LD-4 are connected to cores 311-1 to 311-4, respectively. The individual cores 311-1 to 311-4 are connected, via directional couplers not shown, to cores 312-1 to 312-4 and cores 313-1 to 313-4, respectively. The individual directional couplers are adapted to divide the lights from the cores 311-1 to 311-4 at a predetermined ratio to direct them to the cores 312-1 to 312-4 and cores 313-1 to 313-4. For example, 95% of the light from the core 311-1 is introduced to the core 312-1 and the residual 5% to the core 313-1. Now, the cores 311-1 to 311-4, cores 312-1 to 312-4, and cores 313-1 to 313-4 can be fabricated to the planar lightwave circuit 410 by a method almost similar to that for fabricating the core 16 of the planar lightwave circuit 10 previously shown in FIGS. 4A to 4H.

To the cores 313-1 to 313-4, connected are optical monitors 303-1 to 303-4, respectively. The constitutions and functions of the optical monitors 303-1 to 303-4 are almost similar to those of the foregoing optical device 1 and monitor 303. The individual optical monitors 303-1 to 303-4 comprise the filter block 30, and photodiodes PD1 and PD2 (not shown in FIG. 12). The silicon substrate 420 is etched in specific sites to a depth of for example 300 μm for locating the filter block 30, and photodiodes PD1 and PD2.

On the silicon substrate 420 or in the external thereof, provided are a calculating circuit 440, a control circuit 450 composed of a DSP, APC circuits 160-1 to 160-4 corresponded to the individual laser diodes LD-1 to LD-4, ATC circuits 170-1 to 170-4, and LD drive circuits 330-1 to 330-4. For example, the laser diode LD-1, optical monitor 303-1, cores 311-1 and 313-1 compose a single optical device group. That is, the optical module 401 comprises four optical device groups.

The operations of thus composed optical device 401 of the present embodiment will be described. The individual laser diodes LD-1 to LD-4, driven by the LD drive circuits 330-1 to 330-4, emit laser lights to the cores 311-1 to 311-4 after being converted into single-mode lights by a mode conversion function. Now the laser lights output from the individual laser diodes LD-1 to LD-4 are adjusted to wavelengths differ with each other.

The laser lights input into the cores 311-1 to 311-4 are then individually divided by the directional couplers into a ratio of 95 : 5. Ninety-five percent of the lights are directed by optical fibers 340-1 to 340-4, respectively connected to the cores 312-1 to 312-4, to external optical devices, not shown. Residual 5% of the lights are transmitted through the cores 313-1 to 313-4 to the optical monitors 303-1 to 303-4.

The individual optical monitors 303-1 to 303-4 monitor the introduced lights using the build-in photodiodes PD1 and PD2, and then deliver results of such monitoring to the calculator circuit 440 after converting them into voltage signals V1 and V2. The calculating circuit 440 calculates $(V2 - V1)/V2 = S$ for each of the optical monitors 303-1 to 303-4. The calculated value S and the voltage signal V2 are sent to the control circuitry 450.

The successive real-time control of the laser diode LD is carried out as described for the earliest described embodiment. Thus the four kinds of laser lights having the stable intensities and wavelengths can be provided from the optical module 401 to an external optical device.

As described in the above, the optical module 401 of the present embodiment, having a plurality of laser diodes LD-1 to LD-4 mounted on a single silicon substrate 420, can successfully provide a small-sized WDM sending module.

Controlling the intensities and wavelengths of the laser lights individually output from the laser diodes LD-1 to LD-4 and differing in wavelength by using the single control circuit 450 can facilitate keeping the intensities and wavelengths even.

It also allows to rapidly replace one of those laser diodes with an auxiliary laser diode when operational failure is found.

While the optical module 401 of the present embodiment is composed so that four laser diodes LD-1 to LD-4 have four wavelengths of the output lights which may be different from each other, it is also allowable to alter the number of the laser diodes and correlate them to the number of wavelengths. While the optical module 401 of the present embodiment is composed so that the laser lights individually output from the laser diodes LD-1 to LD-4 are introduced into the optical fibers 340-1 to 340-4, it is also allowable to integrate such laser diodes LD-1 to LD-4 by attaching a waveguide-type filter such as AWG (arrayed waveguide) multiplexer/demultiplexer.

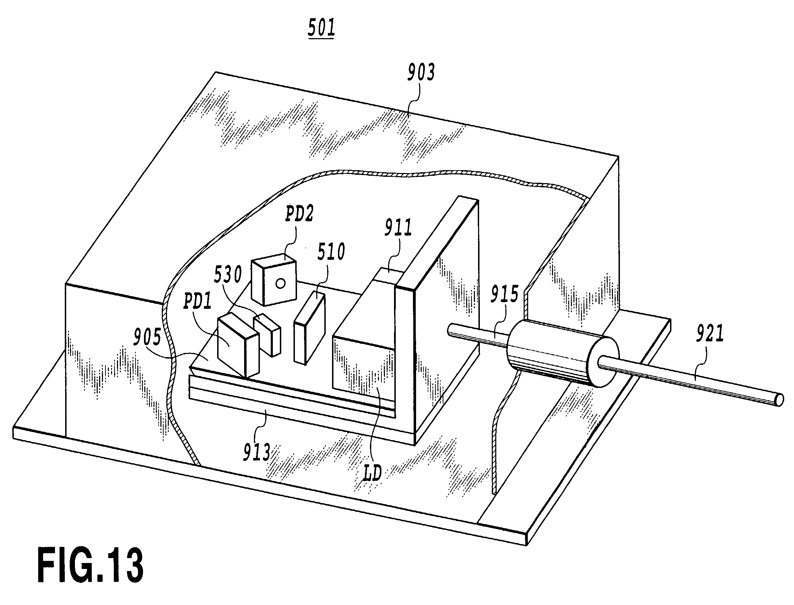

FIG. 13 shows an optical device 501 according to a still further alternative embodiment of the present invention. The optical device 501 has, within a package 903, a stage 905, a laser diode LD, photodiodes PD1 and PD2, a light expander (light expanding lens, which may be a cylindrical lens) 510, a filter 530, a thermistor 911 and a thermoelectric (T/E) cooler 913. Among these, the photodiodes PD1 and PD2, light expander 510, and filter 530 are located at predetermined positions on the stage 905 to thereby compose the optical device.

The optical module 501 also has a fibrous Bragg grating 915 at the output end for the front light from the laser diode LD so as to stabilize oscillating wavelength of the laser diode LD. The output light (front light) from the laser diode LD is transmitted through an optical fiber 921 to an external optical device, not shown.

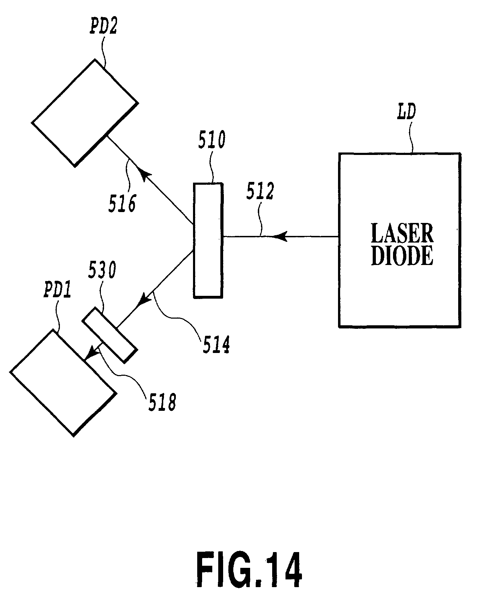

FIG. 14 is a schematic plan view of the interior of the package 903 of the optical module 501 as viewed from the top of such package 903 shown in FIG. 13. As is shown in the figure, the back light 512 of the laser diode LD is expanded in a lateral direction (planar direction) by the light expander 510. The filter 530, and photodiodes PD1 and PD2 are respectively located on the light paths 514 and 516 of the expanded light from the light expander 510. The filter 530 has characteristics such that the transmissivity of the light depends on the wavelength, and is composed, for example, of a dielectric multi-layered film, etalon filter, or fiber Bragg grating.

A part (50% for example) of the expanded light 514 is transmitted through the filter 530 to the photodiode PD1, and the residual part of the light 516 (50% for example) directly to the photodiode PD2. The photodiode PD2 receives the residual part of the expanded light 516 and outputs a voltage signal V2 in dependence upon the intensity thereof. The photodiode PD1 receives only a light 518 of a predetermined wavelength extracted from a part of the expanded light 514 via the filter 530, and outputs a voltage signal V1 according to the intensity thereof. The voltage signals V1 and V2 are then sent, for example, to a control device, not shown, composed of a DSP or the like, where the output power of the laser diode LD is calculated based on the voltage signal V2. The control device also calculates the wavelength of the output light from the laser diode LD by comparing the voltage signals V1 and V2.

The thus obtained intensity and oscillating wavelength of the output light from the laser diode LD are preferably incorporated, as a calibration value for the optical module 501 (for example, as a value for calibrating photo-sensitivity of the photodiodes PD1 and PD2), into an application program which is stored in the control device.

As described in the above, the optical module 501 according to the present embodiment can compactly modularize the laser diode LD together with devices for monitoring the intensity and wavelength of the output light from the laser diode LD.

The constitution of the instant embodiment is advantageous also in that accuracy required for optical alignment of the components such as the filter 530, and photodiodes PD1 and PD2 is not so high as required for the conventional process, since calibration values for the optical module 501 are previously acquired and stored in the control circuit. This facilitates the assembly process and, as a result, reduces the costs.

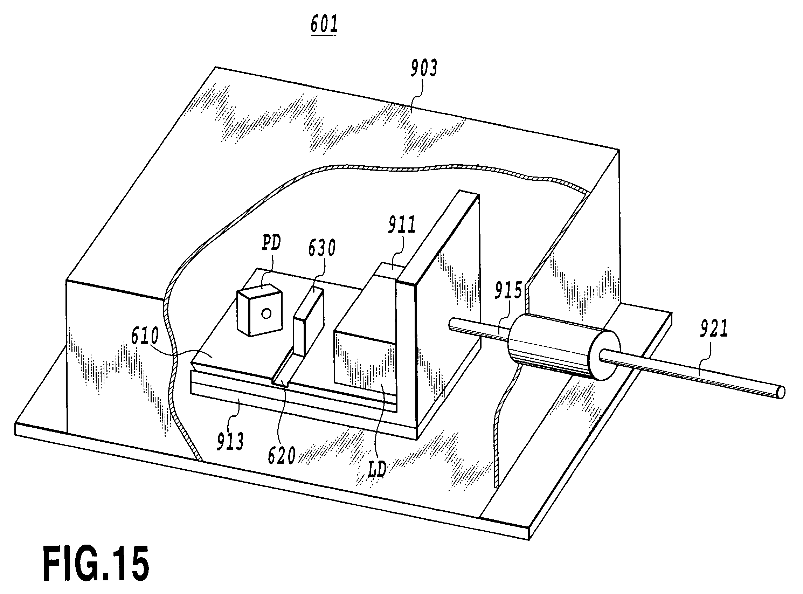

FIG. 15 shows an optical device 601 according to another alternative embodiment of the present invention. The optical device 601 has, within a package 903, a stage 610, a laser diode LD, a photodiode PD, a movable filter 630, a thermistor 911 and a thermoelectric (T/E) cooler 913. Among these, the photodiode PD and the movable filter 630 are located at predetermined positions on the stage 610 to thereby compose an optical device. The stage 610 also has formed thereon a guide groove 620 along which the movable filter 630 can slide.

The optical module 601 also has a fibrous Bragg grating 915 at its output end for the front light from the laser diode LD so as to stabilize the oscillating wavelength of the laser diode LD. The output light (front light) from the laser diode LD is transmitted through an optical fiber 921 to an external optical device, not shown.

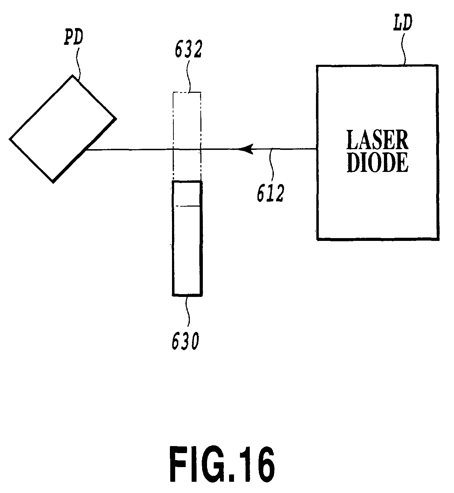

FIG. 16 is a schematic plan view of the interior of the package 903 of the optical module 601 as viewed from the above in FIG. 15 with the package 903 removed. As is shown in the figure, the photodiode PD is placed on the light path of the back light from the laser diode LD. The movable filter 630 is composed, for example, of a dielectric multi-layered film, and movable between a first position 632 (indicated with a broken line) and a second position (indicated with a solid line) by sliding along the guide groove 620.

When the movable filter 630 is positioned at the first position 632, the back light 512 from the laser diode LD is filtered by the movable filter 630, and only an extracted light of a predetermined wavelength can reach the photodiode PD. On the contrary, placing the movable filter 630 at the second position allows the back light 512 to directly reach the photodiode PD.

It is now preferable to employ micro-machine related technologies capable of providing highly precise alignment of the movable filter 630. Since the back light 512 from the laser diode LD is highly directional and only has a broadening of 1 to 2 μm at most, the travel distance of the movable filter 630 (distance between the first and second positions 632 and 630) is as small as 5 μm. Although micro-machines generally require a high voltage for moving over a long distance, they are employable enough as a moving means for the movable filter 630 traveling over such a short distance.

Next, the operations of the constituted optical module 601 according to the present embodiment, in particular operations for monitoring intensity and wavelength of the output light from the laser diode LD, will be described.

First, the movable filter 630 is positioned at the first position 632 so as to allow the back light 512 to pass through the movable filter 630 and to reach the photodiode PD. The photodiode PD outputs a voltage signal V1 to a control circuit, not shown, according to the intensity of the received light.

Next, the movable filter 630 is positioned at the second position so as to allow the back light 512 to directly be received by the photodiode PD. The photodiode PD outputs a voltage signal V2 to the control circuit according to the intensity of the directly received light.

The control circuit calculates the output power of the laser diode LD based on the voltage signal V2. The control circuit also calculates the wavelength of the output light from the laser diode LD by comparing the voltage signals V1 and V2.

As described in the above, using the optical module 601 according to the present embodiment, the back light 512 from the laser diode LD can be monitored by a single photodiode PD, and based on the results of such monitoring, the intensity and wavelength of the output light from the laser diode LD can be calculated. Thus the optical module 601 ensures similar effects as those expected from the optical module 501 according to the immediately preceding embodiment, and can achieve further downsizing.

While the above description was made on the WDM sending module as the typical embodiments of the present invention, the present invention can be adopted also to an electro-optical transducer used for an optical interface or a optical cross connector of a router. It is still also available as an optical performance monitor in optical communications system, and is even applicable to an optical sensor used in fields other than optical communications.

The entire disclosure of Japanese patent application No. 2000-181015 filed on June 16, 2000, including the specification, claims, accompanying drawings and abstract of the disclosure is incorporated herein by reference in its entirety.

While the present invention has been described with reference to the particular illustrative embodiments, it is not to be restricted by the embodiments. It is to be appreciated that those skilled in the art can change or modify the embodiments without departing from the scope and spirit of the present invention.

**Claims**

1. An optical device comprising a first photosensitive device for receiving light,
   **CHARACTERIZED BY**

   an optical divider (16, 16h) for dividing received light into at least a first light and a second light with a predetermined ratio;
   an optical filter (30) for receiving the first light and selectively passing light of a specific wavelength; and
   a second photosensitive device (PD1) for receiving the light transmitted from said optical filter (30);
   said first photosensitive device (PD2) receiving the second light.

2. The optical device in accordance with claim 1, **CHARACTERIZED IN THAT** said optical filter (30) is aligned so as to have an incident angle of the first light of larger than 0°.

3. The optical device in accordance with claim 1 or 2, **CHARACTERIZED IN THAT** said optical divider (16, 16h) comprises a lightwave circuit (10) having a core (16);
   said core (16) comprising:

   an introduction end (16a) for introducing light emitted from a light source (LD);
   a dividing portion (16h) for dividing the introduced light into the first light and the second light;
   a first emission end (16b) for emitting the first light; and
   a second emission end (16c) for emitting the second light.

4. The optical device in accordance with claim 3, **CHARACTERIZED IN THAT** said lightwave circuit (10) further comprises a core (51) for reflected light for introducing the first light after reflected on an incident plane of said optical filter (30).

5. The optical device in accordance with any one of claims 1 to 4, **CHARACTERIZED IN THAT** said optical filter (30)comprises:

an optical waveguide (33) including a core (35);
a filter film (37), provided to cover either end or both ends (35a, 35b) of the core (35) included in said optical waveguide (33), for passing light of a specific wavelength.

6. The optical device in accordance with claim 3, **CHARACTERIZED IN THAT** said optical filter (30) comprising a filter film (37), provided to cover said first emission end (16b), for passing light of a specific wavelength.

7. The optical device in accordance with any one of claims 1 to 6, **CHARACTERIZED BY** further comprising:

a light source (LD) for emitting the light to be received by said optical divider (16, 16h);
an optical coupler circuit (40, 317, 311, 315) for coupling said light source (LD) with said optical divider (16, 16h); and
a substrate (20, 320) having said light source (LD), said optical divider (16, 16h), said optical filter (30), said first and second photosensitive devices (PD2, PD1), and said optical coupler circuit (40, 317, 311, 315) mounted thereon.

8. The optical device in accordance with claim 7, **CHARACTERIZED IN THAT** said optical coupler circuit (40, 317, 311, 315) comprises an optical fiber (16).

9. The optical device in accordance with claim 7, **CHARACTERIZED IN THAT** said optical coupler circuit (40, 317, 311, 315) comprises a lightwave circuit (10).

10. The optical device in accordance with claim 7, **CHARACTERIZED IN THAT** said light source (LD) comprises a semiconductor laser device.

11. The optical device in accordance with claim 10, **CHARACTERIZED IN THAT** back light from said semiconductor laser device (LD) is directed to said optical divider (510).

12. The optical device in accordance with any one of claims 1 to 11, **CHARACTERIZED IN THAT** said optical divider includes a light expansion lens (510) for expanding the light emitted from a light source (LD) and emitting an expanded light containing the first light and the second light.

13. An optical device comprising a photosensitive device placed on a path of light;
**CHARACTERIZED BY**

an optical filter (630) movable between a first position (632) at which light is input and a second position (630) at which light is not input for passing light of a specific wavelength;

said photosensitive device (PD) receiving light transmitted (512) through said optical filter (630) when said optical filter (630) is positioned at the first position (632), and directly receiving the light (512) when said optical filter (630) is positioned at the second position (630).

14. The optical device in accordance with claim 13, **CHARACTERIZED BY** further comprising a light source (LD) for emitting the light.

15. The optical device in accordance with claim 14, **CHARACTERIZED IN THAT** said light source (LD) comprises a semiconductor laser device.

16. The optical device in accordance with claim 15, **CHARACTERIZED IN THAT** the light is back light emitted from said semiconductor laser device (LD).

17. An optical filter comprising:

an optical waveguide (33) including a core (35);
a filter film (37) covering either end or both ends (35a, 35b) of the core (35) included in said optical waveguide (35) for passing light of a specific wavelength; and
a substrate (31) supporting said optical waveguide (33) thereon.

FIG.1

EP 1 164 367 A2

FIG.2

10    16e    30    PD1
16b    16d

20μm

10a  30a

200μm

# FIG.3A

20

Z

16e

16d    5°    30a

X

# FIG.3B

10    16f    PD2
16c

20μm

10b  32a

200μm

# FIG.3C

20

FIG.4A

FIG.4B

FIG.4C

FIG.4D

FIG.4E

FIG.4F

FIG.4G

FIG.4H

**FIG.5A**

**FIG.5B**

FIG.6

EP 1 164 367 A2

**FIG.7**

FIG.8

EP 1 164 367 A2

**FIG.9**

EP 1 164 367 A2

**FIG.10**

**FIG.11**

**FIG.12**

FIG.13

# FIG.14

FIG.15

EP 1 164 367 A2

PD

632

LD

LASER
DIODE

612

630

FIG.16

**FIG.17**
**PRIOR ART**

EP 1 164 367 A2